(19) Europäisches Patentamt / European Patent Office / Office européen des brevets

(11) **EP 2 865 015 B1**

(12) **FASCICULE DE BREVET EUROPEEN**

(45) Date de publication et mention de la délivrance du brevet:
**06.07.2016 Bulletin 2016/27**

(21) Numéro de dépôt: **13730242.8**

(22) Date de dépôt: **19.06.2013**

(51) Int Cl.:
**H01L 31/0232** *(2006.01)*   **H01L 31/0224** *(2006.01)*

(86) Numéro de dépôt international:
**PCT/EP2013/062713**

(87) Numéro de publication internationale:
**WO 2014/001171 (03.01.2014 Gazette 2014/01)**

(54) **ELÉMENT PHOTODÉTECTEUR POUR UNE RADIATION LUMINEUSE INFRAROUGE ET PHOTODÉTECTEUR COMPRENANT UN TEL ÉLÉMENT PHOTODÉTECTEUR**

FOTODETEKTORELEMENT FÜR INFRAROTLICHTSTRAHLUNG UND FOTODETEKTOR MIT SOLCH EINEM PHOTODETEKTORELEMENT

PHOTODETECTOR ELEMENT FOR INFRARED LIGHT RADIATION, AND PHOTODETECTOR INCLUDING SUCH A PHOTODETECTOR ELEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.06.2012 FR 1256075**

(43) Date de publication de la demande:
**29.04.2015 Bulletin 2015/18**

(73) Titulaire: **Commissariat à l'Énergie Atomique et aux Énergies Alternatives 75015 Paris (FR)**

(72) Inventeurs:
- **DUPERRON, Matthieu**
  **F-38000 Grenoble (FR)**
- **ESPIAU DE LAMAESTRE, Roch**
  **F-38000 Grenoble (FR)**
- **GRAVRAND, Olivier**
  **F-38120 Fontanil Cornillon (FR)**

(74) Mandataire: **Croonenbroek, Thomas Jakob et al Innovincia 310 avenue Berthelot 69008 Lyon (FR)**

(56) Documents cités:
**US-A1- 2004 159 775    US-A1- 2009 003 399**

**Description**

La présente invention concerne un élément photodétecteur pour une radiation lumineuse infrarouge, en particulier des photodétecteurs dans le domaine des détecteurs à forte efficacité quantique, notamment à fine couche d'absorption.

On connaît déjà des photodétecteurs quantiques infrarouges. Ceux-ci doivent être refroidis bien en dessous de la température ambiante pour minimiser, voire supprimer dans le semi-conducteur, le processus de génération thermique de porteurs, ou courant d'obscurité, qui entre en compétition avec la photo-génération de porteurs libres, ou signal utile.

Pour réduire ce courant d'obscurité, une voie consiste à diminuer l'épaisseur de la couche de semi-conducteur. De plus, cette voie peut offrir d'autres avantages comme par exemple une augmentation de la vitesse de détection et une réduction du coût de fabrication.

Toutefois, même si le courant d'obscurité est diminué, on constate également une diminution de l'efficacité quantique du photodétecteur, ce qui n'est pas souhaitable étant donné que cela a pour conséquence une diminution du rapport signal sur bruit.

Afin de pallier à cet inconvénient, dans l'état de l'art, on associe au photodétecteur une structure de concentration de photons, ce qui permet de compenser, au moins partiellement, la perte en efficacité quantique et d'obtenir un rapport signal sur bruit amélioré. Ces structures sont généralement sous forme de structures périodiques qui permettent d'exciter des modes se propageant parallèlement à la couche de matériau semi-conducteur absorbant.

Or, on constate que cette mesure n'est pas toujours suffisante. En effet, étant donné que l'on associe pour un photodétecteur en général, plusieurs éléments photodétecteurs sous formes d'une matrice de pixels, dont la taille doit être la plus réduite possible, dans la limite des phénomènes de diffraction de l'optique placé devant le photodétecteur, l'étendue de la structure périodique est limitée et perd de son efficacité de couplage entre l'onde incidente et la structure périodique.

De plus, pour pallier au fait d'une résistance électrique d'accès trop grande, notamment pour les pixels situés au centre de la matrice, il devient nécessaire de positionner des contacts électriques servant à collecter les charges libérées à proximité de chaque pixel.

On connaît en particulier des éléments photodétecteurs avec une collection latérale des charges photogénérées.

Or, la mise en matrice de tels éléments photodétecteurs implique un compromis entre les performances électriques et optiques. D'un point de vue électrique, la résistance d'accès à un pixel du centre de la matrice peut devenir très grande, du fait de l'amincissement de la couche de semi-conducteur absorbant. Il devient alors nécessaire de positionner les deux contacts électriques à proximité de chaque élément photodétecteur. D'un point de vue optique, la taille finie de l'élément photodétecteur impose un nombre fini de périodes au réseau de couplage. Lorsque ce nombre de période devient trop faible, le couplage par le réseau de la radiation lumineuse incidente à la couche absorbante n'est plus optimal, et on observe une baisse de rendement quantique de la photodiode.

Dans ce cas, on se trouve à nouveau en face d'une baisse du rendement quantique et d'une baisse du rapport signal sur bruit.

Face à ces problématiques des solutions suivantes ont été avancées :

Le document WO 2005/081782 propose l'utilisation de couches métalliques en extrémité du réseau de couplage. Ces couches verticales jouent le rôle de « miroirs » permettant des réflexions horizontales et conservant la lumière diffractée dans le pixel. Cependant, les contacts électriques sont pris au-dessus et en dessous de la couche absorbante (connexion électrique « verticale »). Cette proposition ne permet donc pas de régler le problème technique de la résistance d'accès pour les configurations de prise de contact qui nous intéresse.

Le document US 6 133 571 est relatif à un photodétecteur avec des contacts électriques horizontaux sur des surfaces opposées d'une structure de semi-conducteur absorbante. Ce photodétecteur prévoit en outre des réflecteurs verticaux, par exemple en or, formant une cavité pour obtenir des ondes électromagnétiques stationnaires afin de favoriser l'absorption de la couche absorbante. Ces réflecteurs sont isolés électriquement dans tous les modes de réalisation par une couche d'isolation périmétrique, par exemple en $SiO_2$.

Toutefois, cette solution est complexe dans sa réalisation et ne permet pas de résoudre les problèmes évoqués ci-dessus.

La présente invention vise à pallier ces inconvénients précités, au moins en partie.

A cet effet, la présente invention propose un élément photodétecteur pour une radiation lumineuse infrarouge d'une longueur d'onde donnée, comprenant, dans un milieu au moins partiellement transparent à la radiation lumineuse infrarouge à détecter :

- une couche d'un matériau semi-conducteur partiellement absorbant,
- une structure périodique placée à distance en champ proche de la couche de matériau semi-conducteur et excitant des modes de propagation parallèles à cette couche de matériau semi-conducteur de ladite radiation lumineuse infrarouge à détecter, caractérisé en ce qu'il comprend en outre un contact électrique périmétrique qui entoure le contour dudit élément photodétecteur et s'étend perpendiculairement par rapport aux plans définis par la couche de matériau semi-conducteur et ladite structure périodique, qui est en contact avec ladite couche de matériau semi-conducteur, et qui forme également un miroir optique pour les modes excités par ladite structure périodique.

On comprend donc que le contact électrique périmétrique remplit une fonction double, à savoir une fonction électrique d'une part et une fonction optique en tant que réflecteur d'autre part. On a donc étendu la fonctionnalité d'un des contacts électriques nécessaire pour la collecte des charges, ce qui permet de rendre l'élément photodétecteur plus performant tout en ayant une structure simple.

De plus, grâce à la cavité optique formée par le contact électrique périmétrique, la performance de couplage de la structure périodique se trouve renforcée et l'effet de taille finie de la structure périodique se trouve considérablement diminué. On conserve donc un bon rendement quantique et le rapport signal sur bruit peut être amélioré.

De plus, le contact électrique périmétrique permet dans une structure en matrice des éléments photodétecteurs de découpler les éléments photodétecteurs entre eux, de manière qu'il n'y a pas de phénomène de diaphonie (crosstalk en anglais) optique ou électrique.

Enfin, le besoin de refroidissement d'un tel élément photodétecteur se trouve également diminué, ce qui permet une plus grande facilité d'utilisation d'un tel capteur.

L'élément photodétecteur peut en outre comporter les caractéristiques suivantes seules ou en combinaison :

Selon un aspect, pour la longueur d'onde donnée à détecter, la distance entre deux bords opposés du contact électrique périmétrique est choisie pour vérifier une relation de résonance ou de quasi résonance en tenant compte de la structure périodique disposée entre lesdits bords opposés du contact électrique périmétrique.

On peut choisir que les distances entre un bord du contact électrique périmétrique et la structure périodique vérifient les relations :

$$n_{bord} L_{bord-1} + n_{bord} L_{bord-2} + n_{réseau} . L_{réseau} = \frac{k . \lambda_0}{2} \quad (1)$$

$$n_{bord} L_{bord-1} = \frac{k_1 \lambda_0}{2} \quad (2\text{-}1)$$

$$n_{bord} L_{bord-2} = \frac{k_2 \lambda_0}{2} \quad (2\text{-}2)$$

dans la limite de :

$$-\frac{1}{8} \frac{\lambda_0}{n_{bords}} + \frac{k_{1\,ou\,2} . \lambda_0}{2 n_{bord}} \leq L_{bord-1\,ou\,2} \leq \frac{1}{8} \frac{\lambda_0}{n_{bords}} + \frac{k_{1\,ou\,2} . \lambda_0}{2 n_{bord}} \quad (3)$$

où :

$\lambda_0$ est la longueur d'onde à détecter de l'élément photodétecteur,

$L_{bord-1}$ et $L_{Bord-2}$ sont les distances entre le bord du contact électrique périmétrique (13) et le maillon d'extrémité (Me) de la structure périodique (9),

$L_{réseau}$ est la longueur de la structure périodique,

$n_{bord}$ est l'indice effectif du mode d'empilement se propageant dans la zone comprise entre le bord et le contact électrique périmétrique,

$n_{réseau}$ est l'indice effectif du mode se propageant au niveau de la structure périodique, il peut être défini par $A_0/P$,

$k$, $k_1$ et $k_2$ sont des nombres entiers.

Selon un autre aspect, l'épaisseur du contact électrique périmétrique est supérieure à l'épaisseur de l'effet de peau du métal formant le contact périmétrique.

L'extension du contact périmétrique dans une direction perpendiculaire au plan défini par la structure périodique peut être choisie pour réfléchir au moins 50% de l'énergie des modes de propagation de la structure périodique qui sont parallèles à la couche de matériau semi-conducteur.

De plus, l'inclinaison entre le flanc du contact périmétrique en regard de la structure périodique et un plan strictement perpendiculaire au plan défini par la structure périodique est par exemple inférieure à 20°.

L'élément photodétecteur peut comporter en outre une couche formant miroir métallique disposé sur le côté opposé à celui de la radiation infrarouge incidente et le contact périmétrique et la couche formant miroir sont par exemple réalisés en un matériau identique.

Selon un mode de réalisation l'élément photodétecteur est de forme carrée.

Selon un développement, la structure périodique est un réseau carré de motifs carrés ou circulaires.

Selon un autre mode de réalisation, la structure périodique est un réseau linéaire.

Selon encore un autre mode de réalisation l'élément photodétecteur est de forme circulaire et le contact électrique périmétrique et le réseau sont également circulaires.

On peut prévoir que la couche d'un matériau semi-conducteur partiellement absorbant est réalisé sous forme d'une couche double formée par une couche de HgCdTe à petit gap en regard de la structure périodique et dont les bords sont distants d'au moins 200nm des bords du contact électrique périmétrique, et une couche HgCdTe grand gap en contact surfacique avec la couche HgCdTe d'une part et en contact électrique avec le contact électrique périmétrique d'autre part.

L'invention concerne également un photodétecteur pour une radiation lumineuse infrarouge d'au moins une longueur d'onde donnée, caractérisé en ce qu'il comprend une pluralité d'éléments photodétecteurs tels que défini ci-dessus.

Ce photodétecteur peut comprendre une pluralité d'éléments photodétecteurs configurés pour détecter différentes longueurs d'onde données.

Selon un aspect le photodétecteur comprend une matrice d'éléments photodétecteurs dont les contacts périphériques sont reliés et au même potentiel électrique.

D'autres avantages et caractéristiques apparaîtront à la lecture de la description de l'invention, ainsi que des figures suivantes sur lesquelles :

- la figure 1 montre de façon schématique selon une vue dessus une partie d'un photodétecteur, notamment à titre d'exemple une matrice polychromique de quatre éléments photodétecteurs,
- la figure 2 montre de façon schématique en coupe un élément photodétecteur de la figure 1,
- la figure 2A montre une vue en coupe d'un contact électrique périmétrique ayant une forme légèrement trapézoïdale en section transversale,
- la figure 3 montre un empilement de couches d'un élément photodétecteur selon une vue agrandie II de la figure 2,
- la figure 4 montre une variante d'un empilement de couches d'un élément photodétecteur,
- les figures 5A et 5B montrent des résultats comparatifs pour une structure périodique selon le mode de réalisation de la figure 3,
- les figures 6A à 6E montrent de façon schématique un exemple de fabrication d'un élément photodétecteur selon l'invention,
- la figure 7 montre de façon schématique une vue de dessus d'un autre mode de réalisation,
- la figure 8 montre de façon schématique une vue de dessus encore d'un autre mode de réalisation,
- la figure 9 montre de façon schématique une vue de dessus encore d'un autre mode de réalisation.
- la figure 10 montre de façon schématique une vue en coupe d'une variante d'un élément photodétecteur selon l'invention.

Sur toutes les figures, les éléments identiques portent les mêmes numéros de référence.

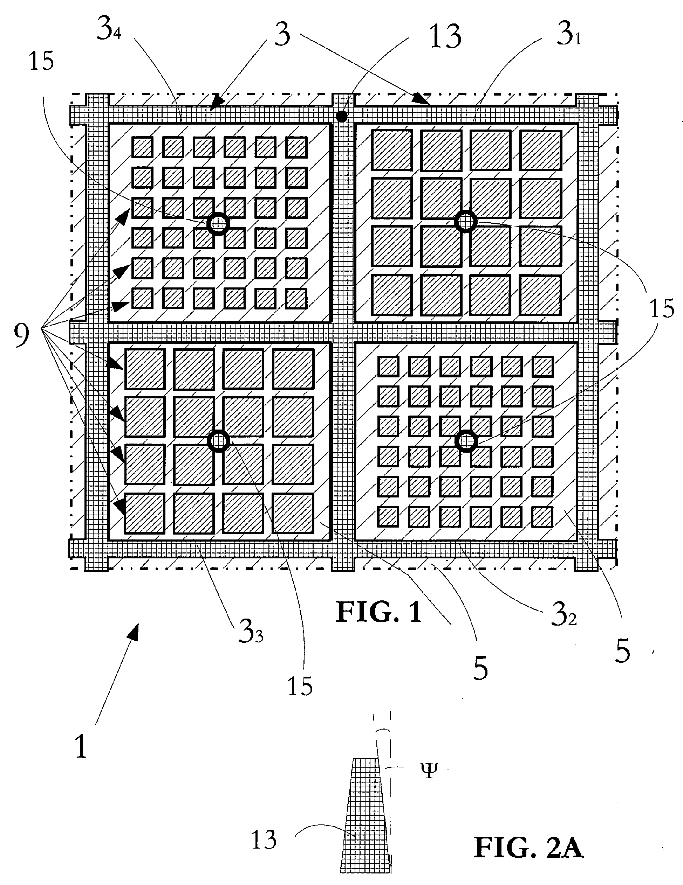

La figure 1 présente un exemple de réalisation d'un photodétecteur 1 pour détecter une radiation lumineuse infrarouge d'au moins une longueur d'onde donnée, dans le présent cas deux longueurs d'ondes différentes.

En effet, on voit sur cette figure de façon schématique par une vue de dessus une pluralité d'éléments photodétecteurs 3 ou pixel, plus en détail quatre éléments photodétecteurs $3_1$, $3_2$, $3_3$ et $3_4$. On peut dire que ces quatre éléments photodétecteurs $3_1, 3_2, 3_3, 3_4$ forment un superpixel.

Selon l'exemple présenté ici, les éléments photodétecteurs respectivement $3_1$ et $3_3$ d'une part et $3_2$ et $3_4$ d'autre part sont identiques et dimensionnés pour détecter la même longueur d'onde.

Bien entendu, on peut prévoir un photodétecteur dont tous les éléments photodétecteurs 3 sont identiques pour détecter la même longueur d'onde, ou encore prévoir d'autres éléments photodétecteurs 3 pour détecter plus que deux longueurs d'onde différentes. Ainsi, on peut obtenir un photodétecteur polychrome.

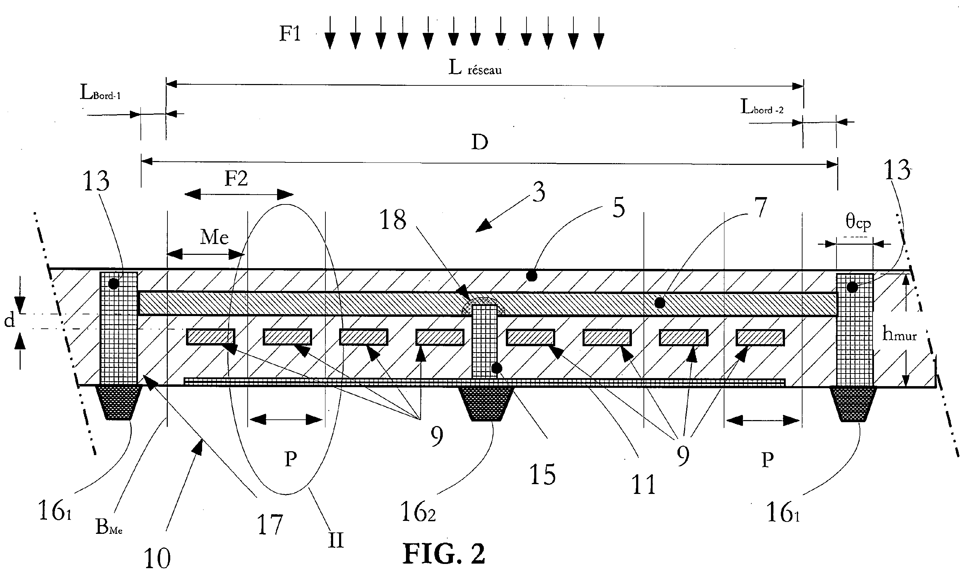

Au regard des figures 1 et 2, on va maintenant décrire plus en détail les éléments photodétecteurs 3.

Vu de dessus sur la figure 1, chaque élément photodétecteur 3 comprend un substrat 5 qui est un milieu au moins partiellement transparent à la radiation de lumineuse infrarouge à détecter. Ce substrat est représenté sur la figure 1 avec des hachures diagonales larges. Il s'agit par exemple du CdTe ou du CdZnTe. Le substrat 5 peut être formé d'une couche en un seul matériau ou d'un empilement de couches en matériaux différents.

En se référant à la figure 2, une couche 7 d'un matériau semi-conducteur partiellement absorbant est disposée dans le substrat 5.

Le matériau semi-conducteur de la couche 7 ainsi que son épaisseur $e$ sont choisis de manière qu'au moins 50% de la radiation lumineuse incidente (indiquée par des flèches F1 sur la figure 2) traverse cette couche 7. Cette condition sur l'épaisseur peut être formulée selon l'équation suivante :

$$e \leq 0.7 * \frac{\lambda_0}{4\pi * k_{SC}}$$

où $\lambda_0$ est la longueur d'onde à détecter de l'élément photodétecteur et $k_{SC}$ est la partie imaginaire de l'indice de réfraction du matériau semi-conducteur absorbant.

Ce matériau pourra être choisi parmi les matériaux suivants : Si, Ge, SiGe, InAs, InSb, GaSb, PbS, PbSe, PbTe ou $Cd_xHg_{1-x}Te$ (avec x<0,9) également appelé MCT pour tellurure cadmium mercure, des alliages ternaires comme InGaAs, AlInAs, AlInSb, InAsSb ou InGaSb, des alliages quaternaires comme InGaAsP ou InGaAsSb et des alliages quinaires comme GaInAsSb ou GaInAsSbP, ou encore un superréseau de type II, par exemple InAs/InSb sur GaSb.

Vu sur la figure 2, en dessous de la couche absorbante 7 est disposée dans le substrat 5 qui peut être un empilement diélectrique de couches en matériaux différents, une structure périodique 9 placée à distance en champ proche de la couche de matériau semi-conducteur 7.

Sur la figure 1, cette structure périodique est représentée par des carrées hachurées 9, la taille des carrées étant différentes entre les éléments photodétecteurs $3_1$ et $3_3$ d'une part et $3_2$ et $3_4$ d'autre part pour symboliser un pas P différent et donc une longueur d'onde différente à détecter.

Cette structure périodique 9 a pour fonction de coupler et de concentrer la lumière incidente dans la couche de matériau semi-conducteur 7. Plus précisément, la structure périodique 9 permet, en excitant des modes de propagation parallèles à cette couche absorbante de matériau semi-conducteur de ladite radiation lumineuse infrarouge à détecter, d'une part le couplage de la lumière incidente F1 dans une direction (double flèche F2) parallèle à la couche de semi-conducteur absorbant 7, et d'autre part la concentration du champ électrique dans cette même couche 7. Elle sert donc à améliorer le rapport signal sur bruit et permet de discriminer spectralement les éléments photodétecteurs 3 (polychromie, spectroscopie...).

La distance d entre la structure périodique et la couche absorbante 7 doit être suffisamment faible pour que cette couche 7 soit dans le champ proche de la structure périodique 9.

Cette condition peut être décrite selon l'équation suivante :

$$d \leq \lambda_0 / n_s$$

où n est l'indice de réfraction du substrat 5.

La structure périodique 9 peut être réalisée (comme montré sur la figure 2) comme un réseau périodique de motifs métalliques dont notamment le pas P permet de régler la longueur d'onde de résonance de la structure périodique 9.

Selon un mode de réalisation, notamment pour les éléments photodétecteurs de forme carrée, la structure périodique 9 est un réseau carré de motifs carrés (voir figure 1).

Des variantes de structures périodiques vont être présentées plus loin.

De plus, comme on peut le voir sur la figure 2, sur la face 10 de l'élément photodétecteur opposée à celle recevant la radiation lumineuse incidente présente une couche réfléchissante formant un miroir 11 (miroir arrière). Il est à noter que cette couche réfléchissante 10 formant miroir est optionnelle dans le cadre de la présente invention, mais sa présence permet d'améliorer de façon significative les performances des éléments photodétecteurs.

La collection des porteurs est réalisée par des contacts électriques 13 et 15 reliés par des bornes respectivement $16_1$ et $16_2$ à une électronique de traitement (non représentée). Dans la cadre de la présente invention, on se situe dans une collection latérale des porteurs, c'est-à-dire que dans la zone de la couche de semi-conducteur absorbant 7 où le champ électromagnétique de la lumière incidente est concentré par la structure périodique 9, les équipotentielles électriques sont sensiblement perpendiculaires à l'axe de la couche 7.

Ainsi, comme on le voit sur la figure 2, les deux contacts électriques 13 et 15 s'étendent de façon sensiblement perpendiculaire par rapport aux plans définis par la couche de matériau semi-conducteur 7 et la structure périodique 9 et sont en contact avec la couche 7 de matériau semi-conducteur absorbante. Dans le cadre de la présente invention et comme cela sera expliqué plus en détail plus loin, par « perpendiculaire », on entend une perpendicularité relative permettant tout de même une inclinaison de surface inférieure à 20°.

Le contact électrique 13 est un contact électrique périmétrique (voir figure 1) qui entoure le contour de l'élément photodétecteur 3.

Comme on le voit sur la figure 1, le contact électrique périmétrique 13 entoure les quatre éléments photodétecteurs 3 et est commun à ces éléments. Il s'agit de l'électrode ou du contact électrique formant la masse électrique commune des éléments photodétecteurs 3.

Comme cela est suggéré sur la figure 1, le superpixel formé par les quatre éléments photodétecteurs peut ne pas être seul, mais adjacent à d'autres superpixels. Dans ce cas, le contact périphérique 13 est prolongé comme montré sur la figure 1 et commun à d'autres superpixels.

Ainsi, par une simple prise de contact en bords de la matrice formée par tous les superpixels, on peut assurer la connexion électrique des contacts 13 de chaque élément photodétecteur.

Les contacts électriques 15 sont disposés par exemple sensiblement au centre de chaque élément photodétecteur 3 (ou pixel) et reliés à une électronique de traitement non représentée.

Selon l'exemple de réalisation de la figure 2, le contact électrique central 15 de l'élément photodétecteur 3 pénètre dans la couche de semi-conducteur absorbant 7.

Selon une variante non représentée, le contact électrique central de chaque élément photodétecteur 3 peut être réalisé de façon à traverser complètement la couche de semi-conducteur absorbant 7.

De plus, on prévoit une zone de dopage 18 dans la couche absorbante de semi-conducteur 7 autour du contact électrique central 15 pour former une diode de collection.

Ces contacts électriques centraux 15 sont propres à chaque élément photodétecteur 3 et permettent de collecter indépendamment les porteurs photogénérés dans chacun des éléments photodétecteurs $3_1$, $3_2$, $3_3$ définissant résolution spatiale du photodétecteur formé d'une matrice d'éléments photodétecteurs comme montré sur la figure 1.

Les contacts électriques 13 et 15 sont réalisés en un métal, par exemple un métal noble, comme de l'or ou de l'argent, ou encore de l'aluminium ou du cuivre, voir un alliage entre ces différents métaux. Les métallisations de contacts électriques telles que décrites dans l'état de l'art, incluant des couches d'adhésion en Ti ou Cr suffisent à assurer la fonction de contact électrique 15 et la double fonction de contact électrique et de réflexion optique pour l'élément 13.

Selon le présent exemple, le contact électrique 15 et la couche 11 formant miroir sont réalisés en un matériau identique. Le contact périmétrique 13 peut être réalisé dans un matériau identique à celui du contact 15 et de la couche 11.

Par ailleurs, comme cela est montré sur la figure 2, la couche 11 formant miroir est en contact avec le contact électrique central 15 mais isolée du contact électrique périmétrique 13. Selon une alternative non représentée, on peut prévoir que la couche 11 formant miroir est en contact avec le contact électrique périmétrique 13 mais isolée du contact électrique central 15.

Il est à noter que les contacts périmétriques 13 possèdent, outre leur fonction électrique pour transporter des charges électriques, une fonction optique en formant pour chaque élément photodétecteur 3 un miroir optique pour les modes excités par la structure périodique 9.

Plus précisément, pour la longueur d'onde donnée à détecter $\lambda_0$, la distance D entre deux bords opposés du contact électrique périmétrique d'un élément photodétecteur 3 est choisie pour vérifier une relation de résonance ou de quasi résonance en tenant compte de la structure périodique 9 disposée entre ces bords opposés du contact électrique périmétrique 13.

Il est à noter que les contacts électriques 15 centraux ne perturbent quasiment pas les modes excités par la structure périodique 9 et leur influence dans la propagation de la radiation lumineuse à détecter selon une direction parallèle à la couche de semi-conducteur absorbant 7 peut être négligée. La relation de résonance ou de quasi-résonance peut également être exprimée par le fait que les distances $L_{Bord-1}$ et $L_{Bord-2}$ entre les bords du contact électrique périmétrique et les structures périodiques vérifient les relations :

$$n_{bord} L_{bord-1} + n_{bord} L_{bord-2} + n_{réseau} \cdot L_{réseau} = \frac{k \cdot \lambda_0}{2} \quad (1) \text{ relation de cavité}$$

$$n_{bord} L_{bord-1} = \frac{k_1 \lambda_0}{2} \quad (2\text{-}1) \text{ relation de phase}$$

$$n_{bord} L_{bord-2} = \frac{k_2 \lambda_0}{2} \quad (2\text{-}2) \text{ relation de phase}$$

dans la limite de :

$$-\frac{1}{8}\frac{\lambda_0}{n_{bords}} + \frac{k_{1\,ou\,2} \cdot \lambda_0}{2n_{bord}} \leq L_{bord-1\,ou\,2} \leq \frac{1}{8}\frac{\lambda_0}{n_{bords}} + \frac{k_{1\,ou\,2} \cdot \lambda_0}{2n_{bord}} \quad (3)$$

où :

$\lambda_0$ est la longueur d'onde à détecter de l'élément photodétecteur,

$L_{bord-1}$ et $L_{Bord-2}$ (voir figure 2) sont les distances entre le bord du contact électrique périmétrique 13 et le maillon d'extrémité Me de structure périodique 9, c'est-à-dire la distance entre ce maillon contenant un motif d'extrémité de la structure périodique 9 et un bord adjacent. Au niveau du bord $B_{Me}$ du maillon d'extrémité Me, le champ électrique est nul pour le mode de propagation horizontal considéré à la longueur d'onde $\lambda_0$. Sur la figure 2, $L_{bord-1}$ et $L_{Bord-2}$ sont identiques ($L_{bord-1} = L_{Bord-2} = L_{bord}$), mais selon d'autres réalisations, elles peuvent avoir des valeurs différentes.

$L_{réseau}$ est la longueur de la structure périodique (voir figure 2),

$n_{bord}$ est l'indice effectif du mode d'empilement se propageant dans la zone comprise entre le bord et le contact électrique périmétrique,

$n_{réseau}$ est l'indice effectif du mode se propageant au niveau de la structure périodique, il peut être défini par $\lambda_0/P$, $k$, $k_1$ et $k_2$ sont des nombres entiers.

Les définitions ci-dessus sont notamment applicables pour des structures périodiques bidimensionnelles, mais peuvent être transposés sans difficultés à des structures périodiques plus complexes, par exemple tridimensionnelles.

En effet, on a constaté que la distance $L_{Bord}$ et donc la disposition du contact électrique périmétrique 13 par rapport à la structure périodique 9 joue sur l'apparition d'interférences destructives ou constructives qui influent sur la performance d'absorption des éléments photodétecteurs 3. Les conditions ci-dessus ont donc pour but de maximiser l'absorption des éléments photodétecteurs 3 en choisissant la distance $L_{Bord}$ pour obtenir plutôt des interférences constructives.

En outre, l'épaisseur $\theta_{cp}$ du contact électrique périmétrique 13 est supérieure à l'épaisseur de l'effet de peau du métal formant le contact périmétrique, c'est-à-dire que $\theta_{cp} \geq \delta(\lambda_0)$. Ceci permet de diminuer, voire supprimer toute transmission d'un mode excité par la structure périodique 9 parallèlement au plan défini par la couche semi-conducteur absorbante 7 et d'éviter des problèmes de diaphonie (« cross-talk » en anglais) entre éléments photodétecteurs 3 d'une matrice de photodétecteurs.

De plus, l'extension $h_{mur}$ du contact périmétrique dans une direction perpendiculaire au plan défini par la structure périodique 9 est choisie pour réfléchir au moins 50% de l'énergie des modes de propagation de la structure périodique qui se propagent parallèlement à la couche de matériau semi-conducteur 7.

Cette relation peut être décrite par la relation suivante :

$$\int_0^{hmur} \varepsilon(z)|E_{mode}(z)|^2 dz \geq 0.5 \int_0^\infty \varepsilon(z)|E_{mode}(z)|^2 dz$$

où $\varepsilon(z)$ est la constante diélectrique des couches de l'élément photodétecteur 3 dans la direction z parallèle à l'extension du contact périmétrique.

Un autre paramètre à prendre en considération est l'inclinaison entre le flanc 17 du contact périmétrique 13 en regard de la structure périodique 9 et un plan strictement perpendiculaire au plan défini par la structure périodique 9. Cet angle d'inclinaison $\psi$ est choisi inférieur à 20° [sur la figure 2, il est 0°].

Sur la figure 2A, on a illustré à titre d'exemple un contact électrique périmétrique 13 dont le flanc est incliné d'un angle $\psi$ et ne serait donc pas strictement perpendiculaire au plan défini par la structure périodique 9.

On a donc compris qu'un élément photodétecteur 3 est un empilement de diverses couches bordées d'un contact périphérique 13 à l'intérieur entre lequel est disposé un motif répétitif de pas P pour former la structure périodique.

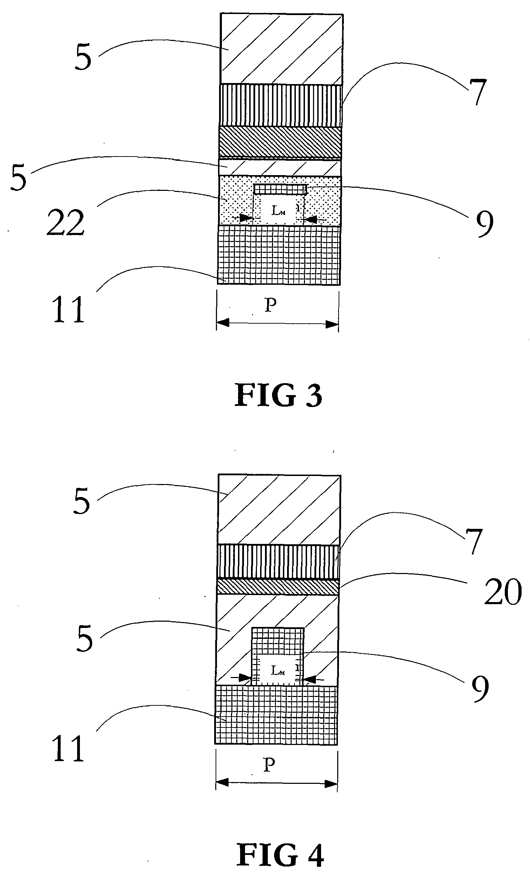

On se réfère maintenant à la figure 3 qui montre en coupe, plus en détail que la figure 2, l'empilement des diverses couches.

Vu sur la figure 3 du haut en bas, c'est-à-dire selon la direction de la radiation lumineuse incidente, on a d'abord une première couche de substrat 5, puis la couche absorbante de matériau semi-conducteur 7, par exemple en MCT d'une épaisseur par exemple de 400 nm environ.

En dessous de la couche 7 est disposée une couche 20 d'ouverture de gap par exemple en $Hg_{1-x}Cd_xTe$ avec un x variable pour passiver la couche de semiconducteur absorbant par exemple d'une épaisseur de 400nm environ.

Puis, il s'ensuit une couche 5 de substrat en CdTe d'environ 100nm d'épaisseur, suivi d'une couche 22 de ZnS d'environ 500 nm d'épaisseur, renfermant la structure périodique 9 d'une épaisseur de 50 nm environ et distant d'environ 50nm de la couche de substrat 5 contiguë à la couche ZnS 22. Le réseau est formé dans le présent cas de plaques carrées métalliques par exemple en or. Enfin, en dessous de la couche 22 est disposée une couche formant le miroir 11 par exemple également en or.

Les indices de réfraction des matériaux pour la gamme 3-5 $\mu$m étudiée ici sont :

$$n(CdTe)=2.67$$

$$n(OG)=3.03$$

$$n(ZnS)=2.25$$

$$n(MCT)=3.4+i*(-5,0e4*\lambda_0+0.454)$$

n (Au) correspond à celui décrit et établi par Palik.

La période P du motif périodique est fixée à 1.5µm afin d'obtenir un élément photodétecteur 3 résonant à 4.3µm. La taille $L_M$ de la plaque carrée métallique vaut 0.5*1.5µm=750nm.

Une alternative de structure périodique 9 est représentée sur la figure 4.

Alors que la structure périodique 9 des figures 2 et 3 est formée de plaques métalliques enfermée dans une couche ZnS et distantes de la couche 11 formant miroir, la structure périodique de la figure 4 est un miroir métallique structuré formé de portions en creux et en relief en alternance avec un pas prédéfini qui permet de régler la longueur d'onde à détecter de la radiation lumineuse infrarouge.

Plus en détail, vu sur la figure 4 du haut en bas, c'est-à-dire selon la direction de la radiation lumineuse incidente, on a d'abord une première couche de substrat 5, puis la couche absorbante de matériau semi-conducteur 7, par exemple en MCT d'une épaisseur par exemple de 200 nm environ.

En dessous de la couche 7 est disposée une couche 20 d'ouverture de gap par exemple en $Hg_{1-x}Cd_xTe$ avec un x variable pour passiver la couche de semiconducteur absorbant, par exemple d'une épaisseur de 100nm environ.

Puis, il s'ensuit une couche 5 de substrat en CdTe d'environ 900nm d'épaisseur dans quelle fait saillie la structure périodique 9 sous forme de plots par exemple en or d'une épaisseur de 600 nm environ et distant d'environ 300nm de la couche d'ouverture de gap 20 contigüe à la couche de substrat 5. Enfin, en dessous de substrat 5 est disposée une couche formant le miroir 11 par exemple également en or. Pour le miroir structuré, on parle également d'une structure gaufrée.

Les indices de réfraction des matériaux pour la gamme 3-5 µm étudiée sont les mêmes que ceux indiqués pour la figure 3.

La période P du motif est de 1.59µm afin d'obtenir une résonance à 4.3µm. La taille $L_M$ du plot est par exemple de 0.4*1.59µm=636nm.

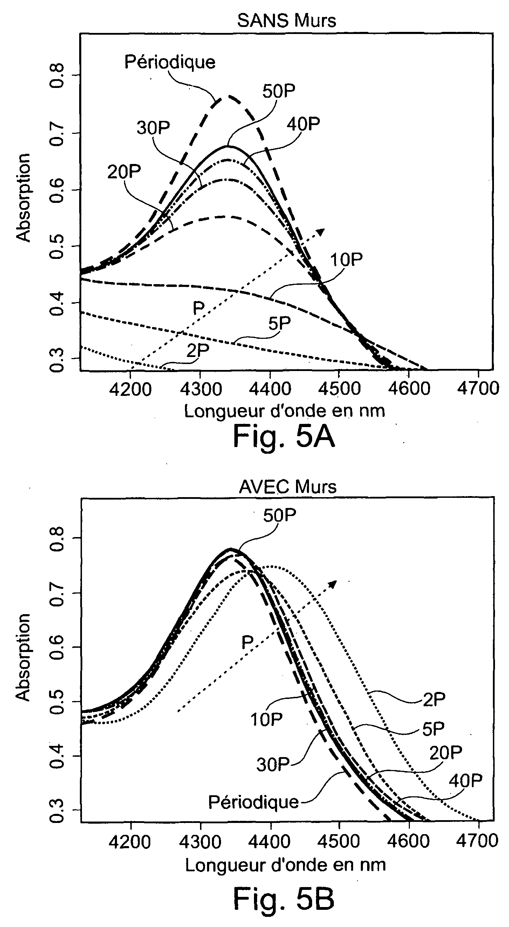

Les figures 5A et 5B présentent le résultat d'une simulation numérique montrant l'avantage que procurent les contacts électriques périmétriques 13 en ayant en même temps une fonction électrique et optique.

La figure 5A montre la réponse en absorption d'un élément photodétecteur avec une structure d'empilement selon la figure 3, mais sans un contact électrique périmétrique. Pour les différentes courbes, on fait varier le nombre de périodes P (P augmente dans le sens de la flèche dans le graphique) contenues dans un seul élément photodétecteur. La courbe en pointillé représente la réponse d'un réseau idéal infini.

On constate donc que pour des éléments photodétecteurs 3 ayant seulement une structure périodique 9 avec un faible nombre de périodes, le rendement est faible et seulement avec plus de 50 périodes, on arrive à peine à un rendement d'environ 90% d'une structure périodique infini.

La figure 5B présente le même résultat pour un élément photodétecteur 3 tel que présenté sur les figures 1 à 3, c'est-à-dire avec des contacts électriques périmétriques 13.

Dans ce cas, même avec un très faible nombre de périodes, voire seulement deux périodes, on arrive à un rendement correspondant déjà à 90% du rendement d'une structure périodique infini idéale.

Cette obtention d'un bon rendement malgré un faible nombre de périodes s'inscrit dans les problématiques de mise en matrice de pixel. Si l'on veut par exemple obtenir des pixels de 15µmx15µm, on remarque qu'avec la solution de l'état de la technique existante sans contact électrique périmétriques faisant également office de miroir, lorsqu'on utilise un réseau de périodicité 1,5µm, résonance dans là bande 3-5µm, on peut disposer seulement 10 périodes dans un élément photodétecteur. La résonance va donc être excitée très faiblement (quelques pourcents de la résonance périodique infini). Avec le contact périmétrique ayant les deux fonctions optiques et électriques, à taille géométrique comparable, on n'obtient plus que 9 périodes de réseau, mais la réponse permet d'obtenir un rendement assez proche de celui d'une structure périodique infini idéale.

De plus, en séparant complètement les éléments photodétecteurs, on évite toute forme de diaphonie (crosstalk). La diaphonie électrique due aux porteurs générés dans un pixel mais collectés dans un autre devient impossible de par la présence du contact électrique périmétrique. La diphonie optique due à l'extension d'un mode optique d'un pixel dans un autre pixel ne peut plus exister à cause de la réflexion des modes sur les flancs métalliques, ceci est particulièrement nécessaire dans le cadre d'une matrice polychromique d'éléments photodétecteurs.

Des résultats comparables mais légèrement moins importants en performance ont été obtenus pour une structure périodique à miroir structuré selon la figure 4.

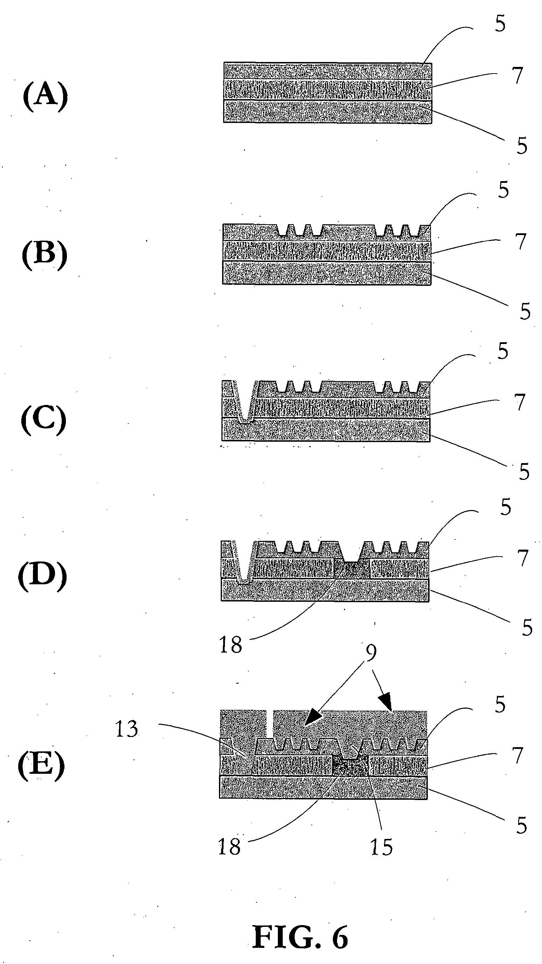

Les figures 6A à 6E montrent de façon schématique et simplifié un exemple de fabrication d'un élément photodétecteur selon l'invention en relation avec le mode de réalisation de la figure 4.

Dans un premier temps, on prépare la surface du substrat 5, par exemple du CdTe, et on dépose par épitaxie par jets moléculaires sur ce substrat 5 une couche de MCT, puis une couche de passivation, par exemple également en CdTe (voir figure 6A).

Puis, par lithographie et gravure, on crée des ouvertures par enlèvement de matière pour former les motifs de la structure périodique 9 (voir figure 6B).

Ensuite, on pratique des ouvertures pour former les contacts périmétriques 13 (voir figure 6C).

Comme on le voit sur la figure 6D, on réalise une ouverture ponctuelle pour le contact central 15 avec une inversion de dopage lors de la gravure pour permettre la formation de la diode de collection.

Enfin, comme montré sur la figure 6E, on réalise une métallisation pour la réalisation finale des contacts périmétriques 13, des contacts centraux 15 et du miroir arrière 11.

Bien entendu, d'autres procédés de réalisation peuvent être envisagés sans sortir du cadre de la présente invention.

Par rapport aux modes de réalisation des figures 1 à 4, de multiples variantes sont envisageables sans sortir du cadre de la présente invention.

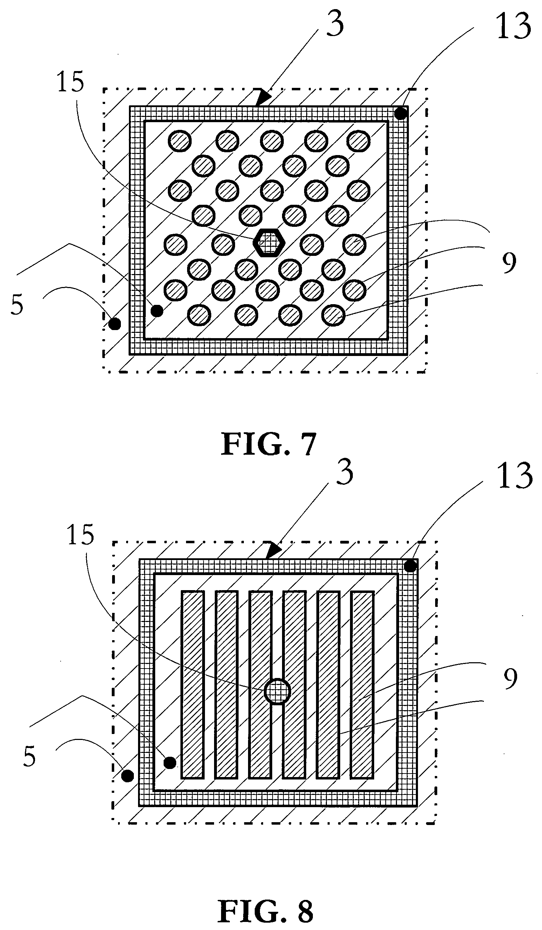

Ainsi, la figure 7 montre un élément photodétecteur 3 de forme carrée, mais avec une structure périodique hexagonale.

La figure 8 montre une variante qui se distingue de celle de la figure 1 par le fait que la structure périodique 9 est un réseau linéaire, ce qui permet de plus de discriminer la polarisation de la radiation lumineuse infrarouge incidente. Ainsi, en disposant par exemple des réseaux de deux éléments photodétecteurs adjacents perpendiculaires l'un par rapport à l'autre, on peut détecter la radiation lumineuse en fonction de la polarisation en plus.

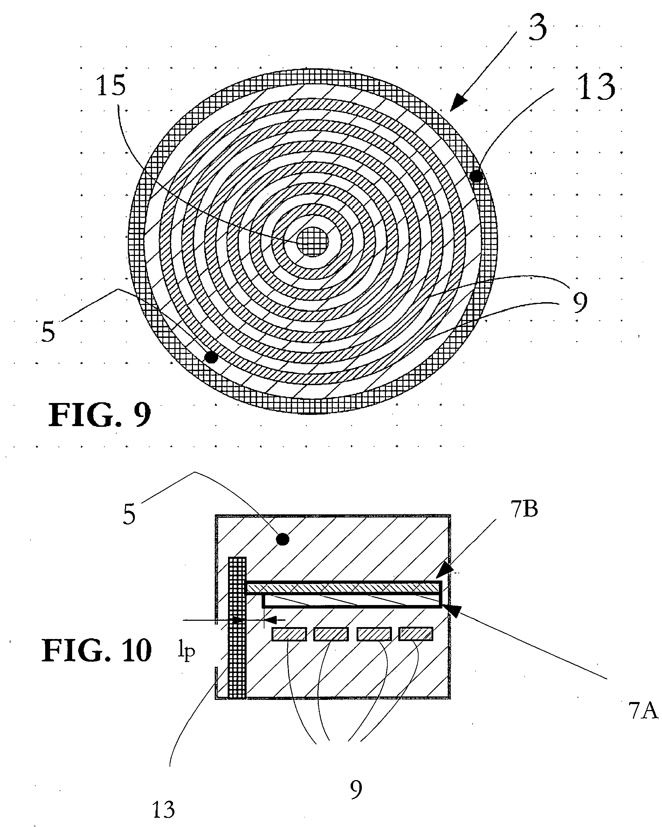

Selon une autre variante montrée sur la figure 9, l'élément photodétecteur 3 est de forme circulaire, le contact électrique périmétrique 13, la structure périodique 9 et le réseau sont de forme circulaire et le contact électrique 15 est réalisé comme un plot central.

Selon encore une autre variante la couche d'un matériau semi-conducteur partiellement absorbant 7 est réalisé sous forme d'une couche double 7A et 7B formée par une couche 7A de HgCdTe à petit gap en regard de la structure périodique 9 et dont les bords sont distants d'une distance $l_p$ de passivation d'au moins 200nm des bords du contact électrique périmétrique 13, et une couche HgCdTe 7B grand gap d'une épaisseur supérieur à 100nm en contact surfacique avec la couche HgCdTe 7A d'une part et en contact électrique avec le contact électrique périmétrique d'autre part. L'avantage de cette configuration est de diminuer la contribution des contacts électriques périmétriques 13 au bruit total de détection, du fait que les contacts 13 sont connectés à un semiconducteur plus grand gap.

Les applications pour ce type de photodétecteur infrarouges couvrent de très nombreux domaines, à la fois civils et militaires. Parmi ce dernier, on citera les autodirecteurs (pour lesquels la fonction de filtrage est critique pour le déleurrage) ou les capteurs embarqués sur drones (compacité et faible coût), et l'équipement léger du fantassin. Dans le domaine civil, les applications sont très diversifiés et peuvent concerner la sécurité des biens et des personnes (surveillance, caméra thermique pour la lutte contre le feu, évitement d'obstacle en conduite de nuit) ; la détection de fuite et le contrôle non destructif dans les installations industrielles (transport de fluide ou d'électricité, transport aérien et ferroviaire) ; le contrôle environnementale (imagerie spatiale ; diagnostic énergétique des bâtiments) ; et enfin le diagnostic médical (inflammations).

On comprend donc que les éléments photodétecteurs présentés ci-dessus permettent de réduire leur taille tout en préservant un rendement quantique et un rapport signal sur bruit importants en minimisant voir supprimer les problèmes de diaphonie.

De plus, il est à noter que la diminution du bruit d'obscurité rend possible une éventuelle augmentation de la température de fonctionnement de ces détecteurs, et donc une diminution du cout du système cryogénique correspondant.

On peut aussi augmenter la bande passante de vitesse de détection, du fait de la taille réduite des photodétecteurs.

Et enfin, on peut rendre éventuellement le photodétecteur sensible à la polarisation de la lumière incidente en utilisant une configuration en lignes et non en plots.

**Revendications**

1. Elément photodétecteur (3) pour une radiation lumineuse infrarouge d'une longueur d'onde donnée, comprenant, dans un milieu (5) au moins partiellement transparent à la radiation lumineuse infrarouge à détecter :

   - une couche (7) d'un matériau semi-conducteur partiellement absorbant,
   - une structure périodique (9) placée à distance en champ proche de la couche (7) de matériau semi-conducteur et excitant des modes de propagation parallèles à cette couche (7) de matériau semi-conducteur de ladite radiation lumineuse infrarouge à détecter,

   **caractérisé en ce qu'**il comprend en outre un contact électrique périmétrique (13) qui entoure le contour dudit élément photodétecteur (3) et s'étend perpendiculairement par rapport aux plans définis par la couche (7) de matériau semi-conducteur et ladite structure périodique (9), qui est en contact avec ladite couche (7) de matériau semi-conducteur, et qui forme également un miroir optique pour les modes excités par ladite structure périodique (9).

2. Elément photodétecteur selon la revendication 1, **caractérisé en ce que** pour la longueur d'onde donnée à détecter, la distance (D) entre deux bords opposés du contact électrique périmétrique (13) est choisie pour vérifier une relation de résonance ou de quasi résonance en tenant compte de la structure périodique (9) disposée entre lesdits bords opposés du contact électrique périmétrique (13).

3. Elément photodétecteur selon la revendication 1 ou 2, **caractérisé en ce que** les distances entre un bord du contact électrique périmétrique et la structure périodique vérifient les relations :

$$n_{bord} L_{bord-1} + n_{bord} L_{bord-2} + n_{réseau} \cdot L_{réseau} = \frac{k \cdot \lambda_0}{2} \quad (1)$$

$$n_{bord} L_{bord-1} = \frac{k_1 \lambda_0}{2} \quad (2\text{-}1)$$

$$n_{bord} L_{bord-2} = \frac{k_2 \lambda_0}{2} \quad (2\text{-}2)$$

dans la limite de :

$$-\frac{1}{8}\frac{\lambda_0}{n_{bords}} + \frac{k_{1\,ou\,2} \cdot \lambda_0}{2 n_{bord}} \leq L_{bord-1\,ou\,2} \leq \frac{1}{8}\frac{\lambda_0}{n_{bords}} + \frac{k_{1\,ou\,2} \cdot \lambda_0}{2 n_{bord}} \quad (3)$$

où :

   $\lambda_0$ est la longueur d'onde à détecter de l'élément photodétecteur,
   $L_{bord-1}$ et $L_{Bord-2}$ sont les distances entre le bord du contact électrique périmétrique (13) et le maillon d'extrémité (Me) de la structure périodique (9),
   $L_{réseau}$ est la longueur de la structure périodique,
   est l'indice effectif du mode d'empilement se propageant dans la zone comprise entre le bord et le contact électrique périmétrique,
   $n_{réseau}$ est l'indice effectif du mode se propageant au niveau de la structure périodique, il peut être défini par $\lambda_0/P$, $k$, $k_1$ et $k_2$ sont des nombres entiers.

4. Elément photodétecteur selon l'une quelconque des revendications précédentes, **caractérisé en ce que** l'épaisseur $(\theta_{cp})$ du contact électrique périmétrique (13) est supérieur à l'épaisseur de l'effet de peau du métal formant le contact périmétrique.

5. Elément photodétecteur selon l'une quelconque des revendications précédentes, **caractérisé en ce que** l'extension $(h_{mur})$ du contact périmétrique (13) dans une direction perpendiculaire au plan défini par la structure périodique (9)

est choisie pour réfléchir au moins 50% de l'énergie des modes de propagation de la structure périodique qui sont parallèles à la couche de matériau semi-conducteur (7).

**6.** Elément photodétecteur selon l'une quelconque des revendications précédentes, **caractérisé en ce que** l'inclinaison (ψ) entre le flanc (17) du contact périmétrique (13) en regard de la structure périodique (9) et un plan strictement perpendiculaire au plan défini par la structure périodique (9) est inférieure à 20°.

**7.** Elément photodétecteur selon l'une quelconque des revendications précédentes comportant en outre une couche (11) formant miroir métallique disposé sur le côté opposé à celui de la radiation infrarouge incidente, **caractérisé en ce que** le contact périmétrique (13) et la couche (11) formant miroir sont réalisés en un matériau identique.

**8.** Elément photodétecteur selon l'une quelconque des revendications précédentes, **caractérisé en ce qu'**il est de forme carrée.

**9.** Elément photodétecteur selon l'une quelconque des revendications précédentes, **caractérisé en ce que** la structure périodique (9) est un réseau carré de motifs carrés ou circulaires.

**10.** Elément photodétecteur selon l'une quelconque des revendications 1 à 8, **caractérisé en ce que** la structure périodique (9) est un réseau linéaire.

**11.** Elément photodétecteur selon l'une quelconque des revendications 1 à 8, **caractérisé en ce qu'**il est de forme circulaire et **en ce que** le contact électrique périmétrique (13) et le réseau sont également circulaires.

**12.** Elément photodétecteur selon l'une quelconque des revendications précédentes, **caractérisé en ce que** la couche (7) d'un matériau semi-conducteur partiellement absorbant est réalisé sous forme d'une couche double (7A, 7B) formée par une couche (7A) de HgCdTe à petit gap en regard de la structure périodique (9) et dont les bords sont distants d'au moins 200nm des bords du contact électrique périmétrique, et une couche (7B) HgCdTe grand gap en contact surfacique avec la couche HgCdTe d'une part et en contact électrique avec le contact électrique périmétrique (13) d'autre part.

**13.** Photodétecteur (1) pour une radiation lumineuse infrarouge d'au moins une longueur d'onde donnée, **caractérisé en ce qu'**il comprend une pluralité d'éléments photodétecteurs (3) selon l'une quelconque des revendications 1 à 12.

**14.** Photodétecteur selon la revendication 13, **caractérisé en ce qu'**il comprend une pluralité d'éléments photodétecteurs ($3_1$, $3_2$, $3_3$, $3_4$) configurés pour détecter différentes longueurs d'onde données.

**15.** Photodétecteur selon la revendication 13, **caractérisé en ce qu'**il comprend une matrice d'éléments photodétecteurs (3) dont les contacts périphériques (13) sont reliés et au même potentiel électrique.

**Patentansprüche**

**1.** Photodetektorelement (3) für eine Infrarotlichtstrahlung mit gegebener Wellenlänge, das in einem für die zu detektierende Infrarotlichtstrahlung wenigstens teilweise durchlässigen Medium (5) Folgendes umfasst:

- eine Schicht (7) aus einem teilweise absorbierenden Halbleitermaterial,
- eine periodische Struktur (9), die in einem Nahfeldabstand von der Schicht (7) aus Halbleitermaterial angeordnet ist und Ausbreitungsmoden dieser zu detektierenden Infrarotlichtstrahlung, die zu dieser Schicht (7) aus Halbleitermaterial parallel sind, erregt,

**dadurch gekennzeichnet, dass** es außerdem einen elektrischen Umfangskontakt (13) aufweist, der den Umriss des Photodetektorelements (3) umgibt und sich senkrecht in Bezug auf Ebenen, die durch die Schicht (7) aus Halbleitermaterial bzw. die periodische Struktur (9) definiert sind, erstreckt und mit der Schicht (7) aus Halbleitermaterial in Kontakt ist und außerdem einen optischen Spiegel für die durch die periodische Struktur (9) erregten Moden bildet.

**2.** Photodetektorelement nach Anspruch 1, **dadurch gekennzeichnet, dass** für die zu detektierende gegebene Wellenlänge der Abstand (D) zwischen zwei gegenüberliegenden Rändern des elektrischen Umfangskontakts (13) gewählt ist, um eine Resonanz- oder Quasiresonanzbeziehung unter Berücksichtigung der zwischen den gegenüberliegenden Rändern des elektrischen Umfangskontakts (13) angeordneten periodischen Struktur (9) zu erfüllen.

3. Photodetektorelement nach Anspruch 1 oder 2, **dadurch gekennzeichnet, dass** die Abstände zwischen einem Rand des elektrischen Umfangskontakts und der periodischen Struktur die folgenden Beziehungen erfüllen:

$$n_{bord}L_{bord-1} + n_{bord}L_{bord-2} + n_{reseau} \cdot L_{reseau} = \frac{k \cdot \lambda_0}{2} \tag{1}$$

$$n_{bord}L_{bord-1} = \frac{k_1 \cdot \lambda_0}{2} \tag{2-1}$$

$$n_{bord}L_{bord-2} = \frac{k_2 \cdot \lambda_0}{2} \tag{2-2}$$

innerhalb der folgenden Grenze:

$$-\frac{1}{8}\frac{\lambda_0}{n_{bords}} + \frac{k_{1\ oder\ 2} \cdot \lambda_0}{2n_{bord}} \leq L_{bord-1\ oder\ 2} \leq \frac{1}{8}\frac{\lambda_0}{n_{bords}} + \frac{k_{1\ oder\ 2} \cdot \lambda_0}{2n_{bord}} \tag{3}$$

wobei

$\lambda_0$ die zu detektierende Wellenlänge des Photodetektorelements ist,
$L_{bord-1}$ und $L_{bord-2}$ die Abstände zwischen dem Rand des elektrischen Umfangskontakts (13) und dem Endglied (Me) der periodischen Struktur (9) sind,
$L_{reseau}$ die Länge der periodischen Struktur ist,
$n_{bord}$ der effektive Index der Stapelmode ist, die sich in der Zone ausbreitet, die zwischen dem Rand und dem elektrischen Umfangskontakt vorhanden ist,
$n_{reseau}$ der effektive Index der Mode ist, die sich auf Höhe der periodischen Struktur ausbreitet und die durch $\lambda_0/P$ definiert sein kann,
$k$, $k_1$ und $k_2$ ganze Zahlen sind.

4. Photodetektorelement nach einem der vorhergehenden Ansprüche, **dadurch gekennzeichnet, dass** die Dicke ($\theta_{cp}$) des elektrischen Umfangskontakts (13) größer ist als die Dicke des Hauteffekts des Metalls, das den Umfangskontakt bildet.

5. Photodetektorelement nach einem der vorhergehenden Ansprüche, **dadurch gekennzeichnet, dass** die Ausdehnung ($h_{mur}$) des Umfangskontakts (13) in einer Richtung senkrecht zu der Ebene, die durch die periodische Struktur (9) definiert ist, gewählt ist, um wenigstens 50 % der Energie der Ausbreitungsmoden der periodischen Struktur, die zu der Schicht (7) aus Halbleitermaterial parallel sind, zu reflektieren.

6. Photodetektorelement nach einem der vorhergehenden Ansprüche, **dadurch gekennzeichnet, dass** die Neigung ($\psi$) zwischen der Seitenfläche (17) des Umfangskontakts (13) gegenüber der periodischen Struktur (9) und einer Ebene, die zu der durch die periodische Struktur (9) definierten Ebene streng senkrecht ist, kleiner als 20° ist.

7. Photodetektorelement nach einem der vorhergehenden Ansprüche, das außerdem eine Schicht (11) umfasst, die einen metallischen Spiegel bildet, der auf der Seite gegenüber jener der auftreffenden Infrarotstrahlung angeordnet ist, **dadurch gekennzeichnet, dass** der Umfangskontakt (13) und die Schicht (11), die den Spiegel bilden, aus dem gleichen Material verwirklicht sind.

8. Photodetektorelement nach einem der vorhergehenden Ansprüche, **dadurch gekennzeichnet, dass** es eine quadratische Form hat.

9. Photodetektorelement nach einem der vorhergehenden Ansprüche, **dadurch gekennzeichnet, dass** die periodische Struktur (9) ein quadratisches Gitter aus quadratischen oder kreisförmigen Mustern ist.

10. Photodetektorelement nach einem der Ansprüche 1 bis 8, **dadurch gekennzeichnet, dass** die periodische Struktur (9) ein geradliniges Gitter ist.

11. Photodetektorelement nach einem der Ansprüche 1 bis 8, **dadurch gekennzeichnet, dass** es kreisförmig ist und dass der elektrische Umfangskontakt (13) und das Gitter ebenfalls kreisförmig sind.

12. Photodetektorelement nach einem der vorhergehenden Ansprüche, **dadurch gekennzeichnet, dass** die Schicht (7) aus einem Halbleitermaterial, die teilweise absorbierend ist, in Form einer Doppelschicht (7A, 7B) gebildet ist, die durch eine Schicht (7A) aus HgCdTe mit kleinem Spalt gegenüber der periodischen Struktur (9), deren Ränder um wenigstens 200 nm von den Rändern der elektrischen Umfangsschicht beabstandet sind, und durch eine Schicht (7B) aus HgCdTe mit großem Spalt in Oberflächenkontakt mit der HgCdTe-Schicht einerseits und in elektrischem Kontakt mit der elektrischen Umfangsschicht (13) andererseits gebildet ist.

13. Photodetektor (1) für Infrarotlichtstrahlung mit wenigstens einer gegebenen Wellenlänge, **dadurch gekennzeichnet, dass** er mehrere Photodetektorelemente (3) nach einem der Ansprüche 1 bis 12 umfasst.

14. Photodetektor nach Anspruch 13, **dadurch gekennzeichnet, dass** er mehrere Photodetektorelemente ($3_1$, $3_2$, $3_2$, $3_4$) umfasst, die konfiguriert sind, verschiedene gegebene Wellenlängen zu detektieren.

15. Photodetektor nach Anspruch 13, **dadurch gekennzeichnet, dass** er eine Matrix aus Photodetektorelementen (3) umfasst, deren Umfangskontakte (13) verbunden sind und auf demselben elektrischen Potential liegen.

## Claims

1. Photodetector element (3) for infrared light radiation of a given wavelength, comprising, in a medium (5) that is at least partially transparent to the infrared light radiation to be detected:

   - a layer (7) of a partially absorbent semiconductor; and
   - a periodic structure (9) placed at distance from and in the near field of the semiconductor layer (7) and exciting propagation modes, parallel to this semiconductor layer (7), of said infrared light radiation to be detected,

   **characterized in that** it furthermore comprises a perimetric electrical contact (13) that frames the outline of said photodetector element (3) and extends perpendicularly relative to the planes defined by the semiconductor layer (7) and said periodic structure (9), which makes contact with said semiconductor layer (7), and that also forms an optical mirror for the modes excited by said periodic structure (9).

2. Photodetector element according to Claim 1, **characterized in that**, for the given wavelength to be detected, the distance (D) between two opposite edges of the perimetric electrical contact (13) is chosen in order to satisfy a resonance or quasi-resonance relationship taking into account the periodic structure (9) arranged between said opposite edges of the perimetric electrical contact (13).

3. Photodetector element according to Claim 1 or 2, **characterized in that** the distances between an edge of the perimetric electrical contact and the periodic structure satisfy the relationships:

$$n_{\text{edge}} L_{\text{edge}-1} + n_{\text{edge}} L_{\text{edge}-2} + n_{\text{array}} . L_{\text{array}} = \frac{k.\lambda_0}{2} \ (1)$$

$$n_{\text{edge}} L_{\text{edge}-1} = \frac{k_1 \lambda_0}{2} (2\text{-}1)$$

$$n_{\text{edge}}L_{\text{edge}-2} = \frac{k_2\lambda_0}{2}(2\text{-}2)$$

in the limit where:

$$-\frac{1}{8}\frac{\lambda_0}{n_{\text{edges}}} + \frac{k_{1or2}.\lambda_0}{2n_{\text{edge}}} \leq L_{\text{edge}-1or2} \leq \frac{1}{8}\frac{\lambda_0}{n_{\text{edges}}} + \frac{k_{1or2}.\lambda_0}{2n_{\text{edge}}} \qquad (3)$$

where:

- $\lambda_0$ is the wavelength to be detected by the photodetector element;
- $L_{\text{edge}-1}$ and $L_{\text{edge}-2}$ are the distances between the edge of the perimetric electrical contact (13) and the end subdivision (Me) of the periodic structure (9);
- $L_{\text{array}}$ is the length of the periodic structure;
- $n_{\text{edge}}$ is the effective index of the stack mode propagating in the zone comprised between the edge and the perimetric electrical contact;
- $n_{\text{array}}$ is the effective index of the mode propagating in the periodic structure, it may be defined by $\lambda_0/P$; and
- $k$, $k_1$ and $k_2$ are integers.

4. Photodetector element according to any one of the preceding claims, **characterized in that** the thickness ($\theta_{\text{cp}}$) of the perimetric electrical contact (13) is larger than the skin depth of the metal forming the perimetric contact.

5. Photodetector element according to any one of the preceding claims, **characterized in that** the extension ($h_{\text{wall}}$) of the perimetric contact (13) in a direction perpendicular to the plane defined by the periodic structure (9) is chosen to reflect at least 50% of the energy of the propagation modes of the periodic structure that are parallel to the semiconductor layer (7).

6. Photodetector element according to any one of the preceding claims, **characterized in that** the inclination ($\psi$) between the flank (17) of the perimetric contact (13) facing the periodic structure (9) and a plane strictly perpendicular to the plane defined by the periodic structure (9) is lower than 20°.

7. Photodetector element according to any one of the preceding claims, furthermore comprising a layer (11) forming a metal mirror arranged on the side opposite that on which the infrared radiation is incident, **characterized in that** the perimetric contact (13) and the mirror layer (11) are made of the same material.

8. Photodetector element according to any one of the preceding claims, **characterized in that** it is square in shape.

9. Photodetector element according to any one of the preceding claims, **characterized in that** the periodic structure (9) is a square array of square or circular features.

10. Photodetector element according to any one of Claims 1 to 8, **characterized in that** the periodic structure (9) is a linear array.

11. Photodetector element according to any one of Claims 1 to 8, **characterized in that** it is circular in shape and **in that** the perimetric electrical contact (13) and the array are also circular.

12. Photodetector element according to any one of the preceding claims, **characterized in that** the partially absorbent semiconductor layer (7) takes the form of a double layer (7A, 7B) formed by a layer (7A) of narrow bandgap HgCdTe facing the periodic structure (9) and the edges of which are distant by at least 200 nm from the edges of the perimetric electrical contact, and a layer (7B) of wide bandgap HgCdTe making surface contact with the HgCdTe layer on the one hand and making electrical contact with the perimetric electrical contact (13) on the other hand.

13. Photodetector (1) for infrared light radiation of at least one given wavelength, **characterized in that** it comprises a plurality of photodetector elements (3) according to any one of Claims 1 to 12.

14. Photodetector according to Claim 13, **characterized in that** it comprises a plurality of photodetector elements ($3_1$,

$3_2$, $3_3$, $3_4$) configured to detect various given wavelengths.

**15.** Photodetector according to Claim 13, **characterized in that** it comprises a matrix (3) of photodetector elements the peripheral contacts (13) of which are connected and at the same electrical potential.

**FIG. 1**

**FIG. 2A**

FIG. 2

F1

L réseau

L Bord-1

L bord -2

D

F2

13

Me

18

3

5

7

θcp

13

d

hmur

17

9

15

11

9

P

16₁

BMe

10

17

II

16₂

P

16₁

EP 2 865 015 B1

5

7

5

22

9

11

$L_M$

P

**FIG 3**

5

7

5

20

9

11

$L_M$

P

**FIG 4**

**SANS Murs**

Fig. 5A

**AVEC Murs**

Fig. 5B

FIG. 6

**FIG. 7**

**FIG. 8**

3

15

13

5

9

**FIG. 9**

5

7B

7A

**FIG. 10** lp

13

9

**EP 2 865 015 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 2005081782 A
- US 6133571 A